(19) Europäisches Patentamt
European Patent Office
Office européen des brevets

(11) **EP 3 128 665 B1**

(12) **EUROPEAN PATENT SPECIFICATION**

(45) Date of publication and mention
of the grant of the patent:
**11.04.2018 Bulletin 2018/15**

(51) Int Cl.:
*H02M 7/00* *(2006.01)*          *H05K 7/14* *(2006.01)*
*H02M 7/5387* *(2007.01)*

(21) Application number: **16179772.5**

(22) Date of filing: **15.07.2016**

(54) **POWER CONVERSION APPARATUS**

STROMRICHTER

APPAREIL DE CONVERSION DE PUISSANCE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.08.2015 JP 2015153443**

(43) Date of publication of application:
**08.02.2017 Bulletin 2017/06**

(73) Proprietor: **Hitachi, Ltd.**
**Tokyo 100-8280 (JP)**

(72) Inventors:
• **SAKURAI, Naoki**
**Tokyo, 100-8280, (JP)**
• **YOSHINARI, Kiyomi**
**Tokyo, 100-8280, (JP)**

(74) Representative: **Beetz & Partner mbB**
**Patentanwälte**
**Steinsdorfstraße 10**
**80538 München (DE)**

(56) References cited:
DE-A1- 3 110 793          JP-A- H04 197 008
JP-A- 2009 171 761     US-A1- 2013 279 085

**Description**

BACKGROUND OF THE INVENTION

Field of the Invention

The present invention relates to a power conversion apparatus with a housing that encloses a power conversion circuit.

Description of Prior Art

In natural energy power supply systems such as solar photovoltaic power generation and wind power generation, which are actively introduced in recent years, a power conditioner which converts a direct current to an alternating current and a frequency conversion apparatus to prevent frequency from varying are used. And now, in data centers for management of data collected over the Internet and from mobile phones, an uninterruptible power supply is used. Thus, the application field of power conversion apparatus is expanding, including traditional motor drives.

Introduction of natural energy power supply systems and a spread of mobile phones are pursued in many countries and regions, and demand for power conversion apparatus is growing rapidly and globally. Along with the growth of the demand, cost reduction is required and, accordingly, downsizing power conversion apparatus is pursued.

However, in consequence of downsizing, a magnetic flux generated by a current flowing through wiring conductors which are arranged in the close vicinity of the inside of the housing of a power conversion apparatus generates an eddy current on the surface of the housing, and the electrical resistance of the housing material generates a loss by Joule heat, which poses a problem that the housing becomes hot.

To address this problem, as related art to suppress heat generation by an eddy current, technical approaches described in Japanese Unexamined Patent Application Publication No. Hei 5(1993)-300630 (Fig. 1) and Japanese Unexamined Patent Application Publication No. Hei 11(1999)-345724 (Fig. 9) are known.

In a technical approach described in Japanese Unexamined Patent Application Publication No. Hei 5(1993)-300630 (Fig. 1), a frame that encloses bus conductors is provided with slits extending along an axial direction of the bus conductors and these slits are covered with a non-magnetic material. Because of large magnetic resistance of the slit portions, a magnetic flux around the frame decreases, an eddy current generated on the frame decreases, and heat generation in the frame is suppressed.

In a technical approach described in Japanese Unexamined Patent Application Publication No. Hei 11(1999)-345724 (Fig. 9), one of non-magnetic metallic plates forming a box surrounding a high-frequency transformer is provided with slits to prevent generation of an eddy current and prevent temperature rise of the non-magnetic metallic plates.

In the related art mentioned above, a geometric relation between wiring conductors or an electric device generating a magnetic flux and the positions of the slits has influence on eddy current magnitude and distribution. Therefore, in the case of power conversion apparatus enclosed in a large housing for a large amount of power, there is a problem that slits, even if provided, fail to sufficiently reduce temperature rise of the housing and the housing becomes hot locally.

US 2013/0279085 A1 discloses an electrical cabinet for photovoltaic components. It includes a plurality of busbars mounted on the base of the cabinet, and a cover may be provided containing the base.

SUMMARY OF THE INVENTION

It is the object of the invention to provide a power conversion apparatus in which temperature rise of its housing due to an eddy current can be suppressed sufficiently.

This object is accomplished by the features of claim 1.

A power conversion apparatus according to the present invention includes a housing which is comprised of metallic plates, a power conversion circuit which is enclosed in the housing, and plural wiring conductors which are arranged inside the housing and connected to the power conversion circuit and through which an alternating current which is a principal current flows. The wiring conductors are disposed close to one lateral side of the housing such that their longitudinal directions are parallel with the one lateral side of the housing. The one lateral side of the housing is provided with plural slits in positions facing with the wiring conductors and along a longitudinal direction of the wiring conductors. The width of the slits is wider than the widths of the respectively allocated conductors.

These slits serve to decrease mutual inductance between the wiring conductors and the housing. It is thus possible to reduce an eddy current that is generated on the housing due to a magnetic flux generated by an alternating current flowing through the wiring conductors. Thereby, it is possible to suppress temperature rise of the housing due to an eddy current.

Problems, structures, and advantageous effects other than those mentioned above will become apparent from the following description of embodiments.

## BRIEF DESCRIPTION OF THE DRAWINGS

Fig. 1A is a schematic diagram to explain generation of an eddy current;
Fig. 1B denotes an equivalent circuit when an eddy current is generated on the housing;
Fig. 2A is a perspective view of an internal structure of a power conversion apparatus which is a first embodiment;
Fig. 2B depicts a planar view of a lateral surface of the housing, the inside of the lateral surface facing with wiring, in the first embodiment;
Fig. 3 depicts one example of a power conversion circuit in a power conversion unit;
Fig. 4 represents a relationship between a ratio between a slit width and a wiring line width and mutual inductance;
Fig. 5A is a perspective view of an internal structure of a power conversion apparatus which is a second embodiment;
Fig. 5B depicts a side view of the housing when viewed from a direction in which the wiring conductors are arranged alongside in the second embodiment; and
Fig. 6 is an external perspective view depicting an outlined structure of a power conversion apparatus which is a third embodiment.

## DETAILED DESCRIPTION OF THE INVENTION

In the following, embodiments of the present invention will be described by way of the drawings. In the drawings, constituent elements marked with the same reference numeral are those that are identical or that have a similar function.

To begin with, a description is provided of a mechanism in which the surface temperature of the housing of a power conversion apparatus rises.

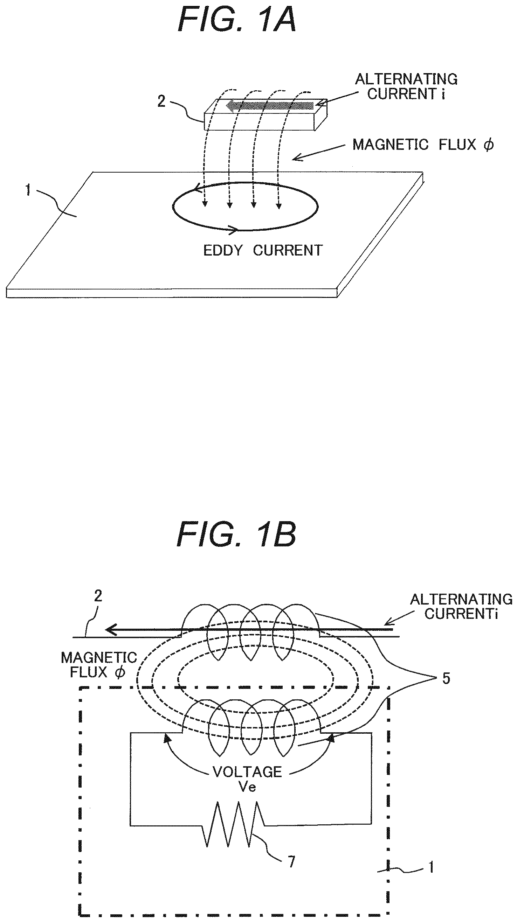

Fig. 1A is a schematic diagram to explain generation of an eddy current. When an alternating current i (e.g., 50 Hz or 60 Hz AC) flows through a wiring conductor 2 that is laid close to a housing 1, a magnetic flux $\phi$ is generated and this magnetic flux generates an eddy current on the surface of the housing 1.

Fig. 1B denotes an equivalent circuit when an eddy current has been generated on the housing 1. The wiring conductor 2 and the housing 1 are equivalently represented by an air core transformer 5. When the alternating current i flows through the wiring conductor 2, a voltage $V_e$ which is expressed by Equation (1) is generated on the surface of the housing 1.

$$V_e = M \times (di/dt) \ \ldots \ (1)$$

where M is mutual inductance of the air core transformer 5 and di/dt is the time rate of change of the current.

Furthermore, given that $R_s$ denotes electrical resistance 7 of an eddy current path, a loss by Joule heat J which is generated by the eddy current is expressed by Equation (2).

$$J = V_e{}^2/R_s = (M \times di/dt)^2/R_s \ \ldots \ (2)$$

Since temperature rise of the housing 1 is proportional to the loss by Joule heat J, temperature rise of the housing 1 is proportional to a square of the mutual inductance (M) of the air core transformer 5 and inversely proportional to the electrical resistance ($R_s$) of the eddy current path, according to Equation (2). di/dt depends on the circuit characteristics of the power conversion apparatus. Therefore, in order to suppress temperature rise depending on how the housing 1 and the wiring conductor 2 are configured, the mutual inductance (M) between the wiring conductor 2 and the housing 1 is decreased or the electrical resistance ($R_s$) of the eddy current path in the housing 1 is increased.

Then, descriptions are provided about an embodiment of the present invention which takes the above-described mechanism of eddy current generation into consideration.

First Embodiment

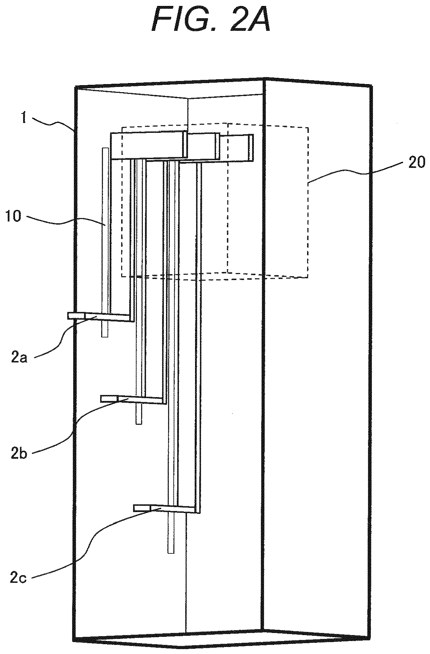

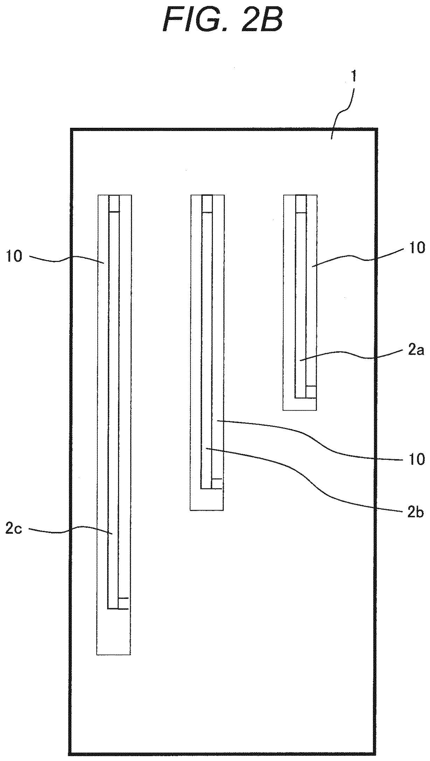

Fig. 2A and Fig. 2B depict an outlined structure of a power conversion apparatus which is a first embodiment of the present invention. Fig. 2A is a perspective view of an internal structure and Fig. 2B depicts a planar view of a lateral surface of the housing with the inside of the lateral surface facing with wiring.

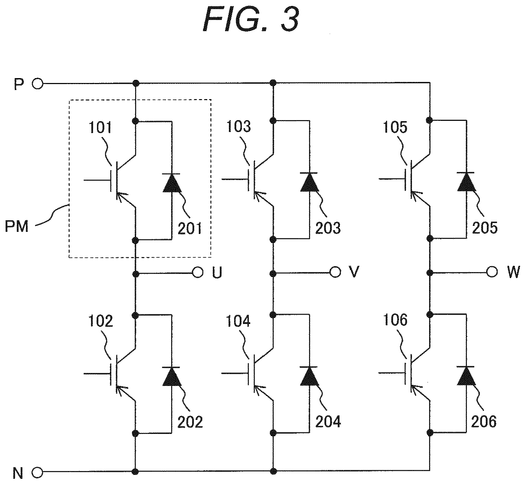

In the first embodiment, a power conversion unit 20 which handles three-phase alternating current power is enclosed in the housing 1. A wiring conductor 2a for phase U, a wiring conductor 2b for phase V, and a wiring conductor 2c for phase W are connected to the power conversion unit 20 inside the housing 1. Thus, an output current of the power conversion unit 20, namely, a three-phase alternating current which is a principal current, flows through the wiring conductors 2a, 2b, and 2c. The housing 1 is comprised of steel plates which are relatively inexpensive as a metallic plate material. The power conversion unit 20 handles a large amount of power (e.g., several MVA or more). The frequency of the output current of the power conversion unit 20 is relatively low (e.g., on the order of several 10 to several 100 Hz at a maximum). One example of a power conversion circuit in the power conversion unit 20 is depicted in Fig. 3.

The power conversion circuit in Fig. 3 converts direct current power to three-phase alternating current power or converts three-phase alternating current power to direct current power by controlling ON/OFF of semiconductor switching elements 101 to 106 (insulated gate bipolar transistors (IGBTs) in Fig. 3). This power conversion circuit includes an upper arm in which a semiconductor switching element 101 and a diode 201 are connected inverse parallel and a lower arm in which a semiconductor switching element 102 and a diode 202 are connected in inverse parallel. Both ends of a circuit in which the upper arm and lower arm are connected in series are connected to direct current terminals P and N (P is a high potential terminal and N is a low potential terminal) and a point of connection between the upper and lower arms is connected to an alternating current terminal U for phase U. Further, both ends of a circuit in which an upper arm comprised of a semiconductor switching element 103 and a diode 203 and a lower arm comprised of a semiconductor switching element 104 and a diode 204 are connected in series are connected to the direct current terminals P and N, respectively, and a point of connection between the upper and lower arms is connected to an alternating current terminal V for phase V. Furthermore, both ends of a circuit in which an upper arm comprised of a semiconductor switching element 105 and a diode 205 and a lower arm comprised of a semiconductor switching element 106 and a diode 206 are connected in series are connected to the direct current terminals P and N, respectively, and a point of connection between the upper and lower arms is connected to an alternating current terminal W for phase W. That is, this power conversion circuit includes three circuits in each of which the upper and lower arms are connected in series according to the number of alternating current phases. And now, although one semiconductor switching element and one diode are depicted to form one arm, plural semiconductor switching elements may be connected in parallel and plural diodes may be connected in parallel in proportion to power capacity. Further, one arm, for example, an upper arm for phase U which is comprised of a semiconductor switching element 101 and a diode 201 may be configured by a power semiconductor module PM.

The wiring conductors 2a, 2b, and 2c depicted in Figs. 2A and 2B are connected to the alternating current terminals U, V, and W, respectively, in Fig. 3.

These wiring conductors 2a, 2b, and 2c are made from flat plate-form bus bars made of a metallic conductor such as a copper material 2a, 2b, 2c to allow a larger current to flow through them. The wiring conductors 2a, 2b, and 2c are laid close to one lateral side of the housing 1 such that their longitudinal planes are parallel with the one lateral side of the housing 1 inside the housing 1. Moreover, in the first embodiment, the wiring conductors 2a, 2b, and 2c are arranged along a height direction of the housing 1 and arranged such that one lateral surface, in a through-thickness direction, of the flat plate-form conductors faces, in the close vicinity of, the one lateral side of the housing 1. In addition, inside the housing 1, the wiring conductors 2a, 2b, and 2c are arranged alongside in substantially evenly spaced positions such that the flat surfaces of the conductors of the flat plate form parallelly face each other. The upper ends of the wiring conductors 2a, 2b, and 2c are positioned at a substantially same height for connection to the power conversion unit 20 located in a top region inside the housing 1. The lower ends of the wiring conductors 2a, 2b, and 2c are positioned at different levels for connection to another circuit section by bending the conductor at right angle and extending it; the lower end position of the wiring conductor 2c is lowest and the lower end position of the wiring conductor 2b is lower than that of the wiring conductor 2a. In this arrangement of the wiring conductors 2a, 2b, and 2c, the flat surfaces of the flat-plate wiring conductors 2a, 2b, and 2c extending in the height direction of the housing overlap with each other. Therefore, it is possible to reduce a space where the wiring conductors 2a, 2b, and 2c are installed in conjunction with means for reducing an eddy current which will be described later and it is possible to reduce the dimensions of the housing 1, in other words, the dimensions of the power conversion apparatus.

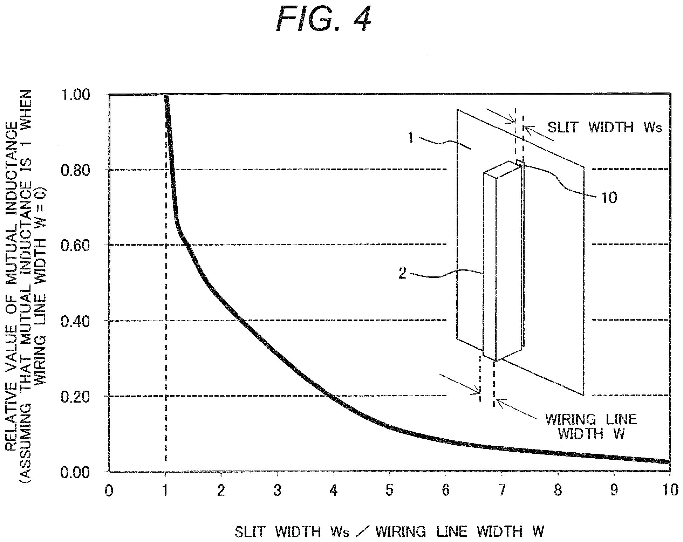

In the first embodiment, furthermore, as depicted in Fig. 2A, one lateral side of the housing 1 is provided with elongated slits 10 in positions facing with one lateral surface, in a through-thickness direction, of each of the flat plate-form wiring conductors 2a, 2b, and 2c; the elongated slits 10 define opening portions on the one lateral side of the housing 1. The lengths of the slits 10 which respectively face with the wiring conductors 2a, 2b, and 2c have dimensions that are substantially equal to the lengths of the wiring conductors 2a, 2b, and 2c in the height direction of the housing, in order words, in their longitudinal direction and equal to at least the lengths of the conductors except for their portions for connection to the power conversion unit 20. Further, as depicted in Fig. 2B, in the appearance of the one lateral side of the housing 1, the widths (corresponding to W in Fig. 4), in a through-thickness direction, of the wiring conductors 2a, 2b, and 2c are smaller than the widths (corresponding to Ws in Fig. 4) of the slits 10 in a direction perpendicular to their longitudinal direction. Therefore, the substantially whole of each of the wiring conductors 2a, 2b, and 2c in the height direction of the housing is positioned within each of the slits 10.

These slits 10 serve to reduce a magnetic flux that is generated by the three-phase alternating current flowing through the wiring conductors 2a, 2b, and 2c and interlinked with one lateral side of the housing, the lateral side facing with the wiring conductors. Consequently, the mutual inductance M between the wiring conductors 2a, 2b, and 2c and the housing 1 is decreased. Therefore, even if the wiring conductors are arranged in a narrow space inside the housing 1 and the clearance between the housing 1 and the wiring 2 is reduced in a manner of arrangement and configuration of the wiring conductors inside the housing, as described previously, it is possible to suppress temperature rise of the surface of the housing 1 due to an eddy current. Moreover, because the mutual inductance M between the wiring conductors 2a, 2b, and 2c and the housing 1 is decreased by means of the slits 10, it is possible to reduce an eddy current on the surface of the housing 1, even if the housing is comprised of steel plates that are of a magnetic material as in the first embodiment.

And now, according to an examination made by the present inventors, in an instance where wiring conductors are laid with their longitudinal direction along the height direction of the housing, as in the first embodiment inside the housing, heat that is generated by an eddy current generated by an alternating current flowing through the wiring conductors is carried upward by air and, thus, temperature in the vicinity of the upper ends of the wiring conductors 2 goes up. Taking such a phenomenon into consideration, in the first embodiment, the slits are provided to extend along only the height direction among the height and other directions of the wiring conductors 2a, 2b, and 2c. Thereby, there is a decrease in working man-hours for forming the slits 10 in the housing 1 and, accordingly, the manufacturing cost of the power conversion apparatus can be saved. Further, in order to decrease the mutual inductance more effectively, the widths of the slits should be wider than the widths, in a through-thickness direction, of the wiring conductors 2a, 2b, and 2c, as depicted in Fig. 2B and as will be described later; however, in the present embodiment, elongated slits 10 are provided on one lateral side of the housing 1, the lateral side facing with one lateral surface, in a through-thickness direction, of each of the flat plate-form wiring conductors 2a, 2b, and 2c. Thus, an increase in the opening areas of the slits 10 is suppressed. This can lead to suppressing dust getting into the housing from the opening portions.

Fig. 4 represents a relationship between a ratio between a slit width Ws and the width, in a through-thickness direction, of a wiring conductor, i.e., wiring line width and the mutual inductance between the wiring conductors 2 and the housing 1, based on the examination by the present inventors. A value of the mutual inductance is a relative value assuming that the mutual inductance is 1 when the wiring line width W = 0.

In a range where Ws/W is at or below 1, that is, the slit width Ws is equal to or smaller than the wiring line width W, an effect of decreasing the mutual inductance is so quite small that it cannot be indicated clearly in Fig. 4. But, in a range where Ws/W is more than 1, that is, the slit width Ws is larger than the wiring line width W, the mutual inductance decreases significantly. According to an examination made by the present inventors, this is because a major part of magnetic flux that is interlinked with the housing within a magnetic flux generated by the current flowing through the wiring conductors is generated in the periphery of the wiring conductors, that is, in a space out of the range of the width of each wiring conductor. That is, on one lateral side of the housing, the lateral side adjacently facing the wiring conductors, opening portions whose area widens beyond the range of the width W of each wiring conductor from within the range should be provided, in other words, slits whose width Ws (> W) is wider than the wiring line width W should be provided, thereby enabling it to decrease an interlinkage magnetic flux certainly. Accordingly, in the first embodiment, in order to suppress temperature rise of the housing due to an eddy current, it is preferable to make the slit width Ws larger than the wiring line width W, as depicted in Fig. 2B.

Second Embodiment

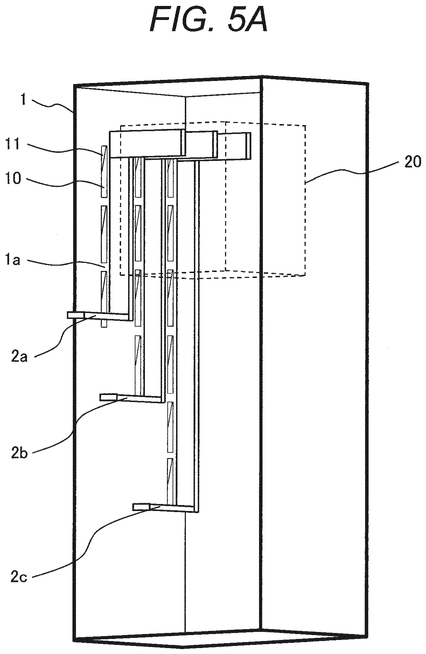

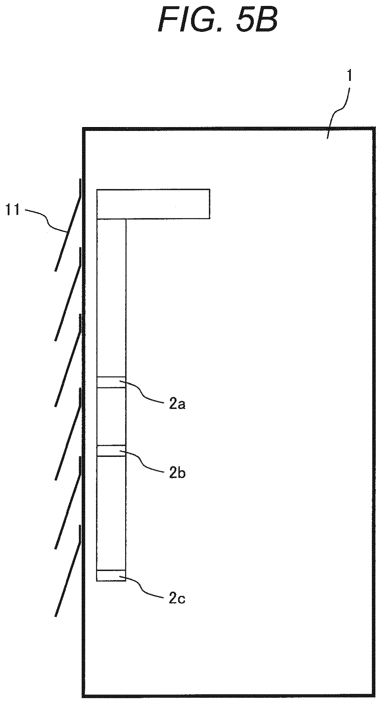

Fig. 5A and Fig. 5B depict an outlined structure of a power conversion apparatus which is a second embodiment of the present invention. Fig. 5A is a perspective view of an internal structure and Fig. 5B depicts a side view of the housing 1 when viewed from a direction in which the wiring conductors 2a, 2b, and 2c are arranged alongside. Descriptions are provided below about what differs from the first embodiment.

In the second embodiment, the slits 10 facing with the wiring conductors 2a, 2b, and 2c are each separated into several ones along a height direction and separated slits are provided with eaves 11, respectively. By providing the eaves 11, it is possible to prevent foreign matters such as dust from getting into the housing from outside.

As depicted in Fig. 5A, there remains a portion 1a of the housing between separated slit sections. As depicted in Fig. 5B, one end of a thin plate material of which an eave 11 is made is fixed onto the outside surface of the portion 1a of the housing and the thin plate material is bent and set at an angle outward from the housing, in order words, toward a direction far from the wiring conductors. Accordingly, even if the eaves 11 are made of a steel plate material as with the housing, practically no eddy current flows in the eaves 11 and the effect of the slits 10 remains intact.

The eaves 11 may be of arbitrary material such as metal and resin. Further, when forming the slits, on a housing surface where the slits 10 should be formed, the slits 10 and the eaves 11 may be formed at the same time and the eaves may be configured integrally with the housing surface, without solely creating slit holes in the surface.

Third Embodiment

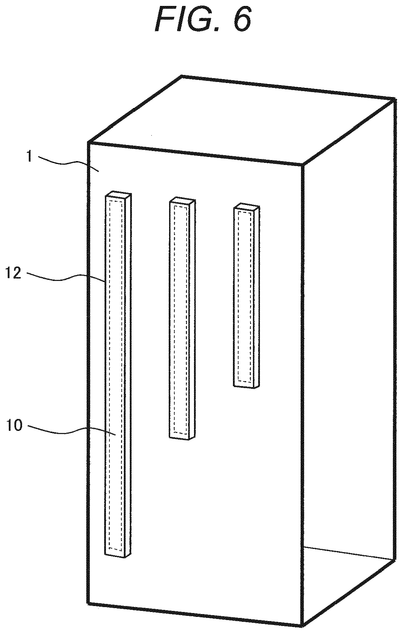

Fig. 6 depicts an outlined structure of a power conversion apparatus which is a third embodiment of the present invention. Fig. 6 is an external perspective view when viewing a housing surface (lateral side) where the slits 10 are provided from outside. Descriptions are provided below about what differs from the first embodiment.

In the third embodiment, on the outside of one lateral side of the housing 1, where the slits 10 are provided, covers 12 of a thin flat plate form, made of non-magnetic metal (e.g., aluminum and stainless steel), are provided to cover the slits 10.

A magnetic flux that is generated by the three-phase alternating current flowing through the wiring conductors 2a, 2b, and 2c is also interlinked with the covers 12. But, practically no eddy current is generated in the covers 12 in the third embodiment because the magnetic permeability of non-magnetic metal which is the material of the covers 12 is lower than that of a steel plate material of which the housing 1 is made. Accordingly, temperature rise of the surface of the housing 1 is suppressed. Moreover, because the slits 10 which define opening portions on the lateral side of the housing are covered by the covers 12, it is possible to prevent foreign matters such as dust from getting into the housing from outside.

The shape of the covers 12 is not limited to a flat plate form and may be a foil form or sheet form. By providing the covers of a flat plate form (with a thickness on the order of 1 mm to several millimeters), as in the present embodiment, the strength of the housing's lateral side where the slits 10 are provided can be enhanced. If the covers 12 of a foil form or sheet form are applied, the housing's lateral side where the slits 10 are provided can be flattened, and the covers 12, even if installed, practically does not augment the weight of the power conversion apparatus.

The present invention is not limited to the embodiments described hereinbefore and various modifications are included therein. For example, the foregoing embodiments are those described in detail to explain the present invention clearly and the invention is not necessarily limited to those including all components described. For a subset of the components of each embodiment, other components can be added to the subset or the subset can be removed or replaced by other components.

For example, the material of the housing is not limited to steel plates and may be other metallic materials. For example, even if the housing is made of a non-magnetic metal, an eddy current that is too large to ignore may be generated if the frequency of the current is high; in that case, the slits on a lateral side of the housing can serve to suppress eddy current generation.

The covers 12 to cover the slits 10 in Fig. 6 may be made using a mesh-form or grid-form member.

The number of phases of alternating current power that the power conversion apparatus handles may be plural, not limited to three phases. In this case, the number of wiring conductors should be a plural number equivalent to the number of alternating current phases.

Furthermore, the power conversion circuit is not limited to the one depicted in Fig. 3; as this circuit, a multi-level inverter circuit of three levels or more, a serial multiple inverter circuit, etc. can be applied. Further, the semiconductor switching element is not limited to IGBT; as this element, a Gate Turn-Off thyristor (GTO thyristor) and the like can be applied.

**Claims**

1. A power conversion apparatus comprising:

   a housing (1) which is comprised of metallic plates;
   a power conversion circuit which is enclosed in the housing; and
   a plurality of wiring conductors (2a, 2b, 2c) which are arranged inside the housing and connected to the power conversion circuit and through which an alternating current which is a principal current flows,
   wherein the wiring conductors are laid close to one lateral side of the housing such that their longitudinal directions are parallel with the one lateral side of the housing, wherein close means that a magnetic flux generated by a current flowing through the wiring conductors can generate an eddy current on the surface of the housing,
   **characterized in that**
   the one lateral side of the housing is provided with a plurality of elongated slits (10) in positions facing the wiring conductors and along a longitudinal direction of the wiring conductors, wherein the width (Ws) of each of the slits is wider than the width (W) of each of the wiring conductors.

2. The power conversion apparatus according to claim 1, wherein the longitudinal direction of the wiring conductors is a height direction of the housing.

3. The power conversion apparatus according to claim 2, wherein the slits are provided only along the height direction of the housing.

4. The power conversion apparatus according to claim 1, wherein the length of each of the slits is equal to the length of each of the wiring conductors in the longitudinal direction.

5. The power conversion apparatus according to claim 1, wherein the slits are provided with a plurality of eaves, respectively.

6. The power conversion apparatus according to claim 5, wherein the eaves are set at an angle outward from the housing.

7. The power conversion apparatus according to claim 1, wherein the slits are covered with a non-magnetic object.

8. The power conversion apparatus according to claim 1, wherein the metallic plates are steel plates.

9. The power conversion apparatus according to claim 1, wherein the power conversion circuit performs power conversion by controlling ON/OFF of semiconductor switching elements and the wiring conductors are connected to alternating current terminals of the power conversion circuit.

10. The power conversion apparatus according to claim 1, wherein the wiring conductors have a flat plate form and one lateral surface, in a through-thickness direction, of the flat plate form faces the one lateral side of the housing, and the through-thickness direction is a width direction of the wiring conductors.

11. The power conversion apparatus according to claim 10, wherein the wiring conductors are arranged alongside such that the flat surfaces of the conductors of the flat plate form face each other.

**Patentansprüche**

1. Stromrichter-Vorrichtung, die umfasst:

ein Gehäuse (1), das aus Metallplatten zusammengesetzt ist,
eine Stromrichter-Schaltung, die in dem Gehäuse eingeschlossen ist, und
mehrere Verdrahtungs-Leiter (2a, 2b, 2c), die innerhalb des Gehäuses angeordnet und mit der Stromrichter-Schaltung verbunden sind und durch die ein Wechselstrom fließt, welcher der Hauptstrom ist,
wobei die Verdrahtungs-Leiter nahe an einer lateralen Seite des Gehäuses so verlegt sind, dass ihre Längsrichtungen parallel zu der einen lateralen Seite des Gehäuses sind,
wobei nahe bedeutet, dass ein magnetischer Fluss, der durch einen Strom erzeugt wird, der durch die Verdrahtungs-Leiter fließt, einen Wirbelstrom auf der Oberfläche des Gehäuses erzeugen kann,
**dadurch gekennzeichnet, dass**
die eine laterale Seite des Gehäuses mit mehreren länglichen Schlitzen (10) in Positionen versehen ist, die den Verdrahtungs-Leitern gegenüber liegen und die längs der Längsrichtung der Verdrahtungs-Leiter verlaufen,
wobei die Breite (Ws) von jedem der Schlitze breiter ist als die Breite (W) von jedem der Verdrahtungs-Leiter.

2. Stromrichter-Vorrichtung nach Anspruch 1, bei der die Längsrichtung der Verdrahtungs-Leiter eine Höhenrichtung des Gehäuses ist.

3. Stromrichter-Vorrichtung nach Anspruch 2, bei der die Schlitze nur längs der Höhenrichtung des Gehäuses vorgesehen sind.

4. Stromrichter-Vorrichtung nach Anspruch 1, bei der die Länge von jedem der Schlitze gleich der Länge von jedem der Verdrahtungs-Leiter in der Längsrichtung ist.

5. Stromrichter-Vorrichtung nach Anspruch 1, bei der die Schlitze jeweils mit mehreren Schutzstreifen versehen sind.

6. Stromrichter-Vorrichtung nach Anspruch 5, bei der die Schutzstreifen unter einem von dem Gehäuse nach außen gerichteten Winkel eingestellt sind.

**7.** Stromrichter-Vorrichtung nach Anspruch 1, bei der die Schlitze mit einem nichtmagnetischen Gegenstand abgedeckt sind.

**8.** Stromrichter-Vorrichtung nach Anspruch 1, bei der die Metallplatten Stahlplatten sind.

**9.** Stromrichter-Vorrichtung nach Anspruch 1, bei der die Stromrichter-Schaltung das Stromrichten durch EIN/AUS-Steuerung von Halbleiter-Schaltelementen durchführt und die Verdrahtungs-Leiter mit Wechselstrom-Anschlüssen der Stromrichter-Schaltung verbunden sind.

**10.** Stromrichter-Vorrichtung nach Anspruch 1, bei der die Verdrahtungs-Leiter die Form einer flachen Platte besitzen und eine Seitenfläche der Form der flachen Platte in einer Dickenrichtung der einen lateralen Seite des Gehäuses gegenüber liegt und die Dickenrichtung eine Richtung der Breite der Verdrahtungs-Leiter ist.

**11.** Stromrichter-Vorrichtung nach Anspruch 10, bei der die Verdrahtungs-Leiter so längsseits zueinander angeordnet sind, dass die flachen Flächen der in Form einer flachen Platte ausgebildeten Leiter einander gegenüber liegen.


**Revendications**

**1.** Appareil de conversion d'énergie comprenant :

un logement (1) qui est composé de plaques métalliques ;
un circuit de conversion d'énergie qui est renfermé dans le logement ; et
une pluralité de conducteurs de câblage (2a, 2b, 2c) qui sont agencés à l'intérieur du logement et connectés au circuit de conversion d'énergie et par lesquels un courant alternatif qui est un courant principal passe,
dans lequel les conducteurs de câblage sont disposés proches d'un côté latéral du logement de telle manière que leurs sens longitudinaux sont parallèles avec le côté latéral du logement,
dans lequel proches signifie qu'un champ magnétique généré par un courant passant par les conducteurs de câblage peut générer un courant de Foucault sur la surface du logement,
**caractérisé en ce que**
le côté latéral du logement est prévu avec une pluralité de fentes allongées (10) en des positions faisant face aux conducteurs de câblage et le long d'un sens longitudinal des conducteurs de câblage, dans lequel la largeur (Ws) de chacune des fentes est plus large que la largeur (W) de chacun des conducteurs de câblage.

**2.** Appareil de conversion d'énergie selon la revendication 1, dans lequel le sens longitudinal des conducteurs de câblage est un sens de la hauteur du logement.

**3.** Appareil de conversion d'énergie selon la revendication 2, dans lequel les fentes ne sont prévues que le long du sens de la hauteur du logement.

**4.** Appareil de conversion d'énergie selon la revendication 1, dans lequel la longueur de chacune des fentes est égale à la longueur de chacun des conducteurs de câblage dans le sens longitudinal.

**5.** Appareil de conversion d'énergie selon la revendication 1, dans lequel les fentes sont prévues avec une pluralité de surplombs, respectivement.

**6.** Appareil de conversion d'énergie selon la revendication 5, dans lequel les surplombs sont fixés à un angle vers l'extérieur par rapport au logement.

**7.** Appareil de conversion d'énergie selon la revendication 1, dans lequel les fentes sont recouvertes avec un objet non magnétique.

**8.** Appareil de conversion d'énergie selon la revendication 1, dans lequel les plaques métalliques sont des plaques d'acier.

**9.** Appareil de conversion d'énergie selon la revendication 1, dans lequel le circuit de conversion d'énergie exécute une conversion d'énergie en commandant l'activation/désactivation d'éléments de commutation à semi-conducteurs et les conducteurs de câblage sont connectés à des bornes de courant alternatif du circuit de conversion d'énergie.

10. Appareil de conversion d'énergie selon la revendication 1, dans lequel les conducteurs de câblage ont une forme de plaque plate et une surface latérale, dans un sens de l'épaisseur, de la forme de plaque plate fait face au côté latéral du logement, et le sens de l'épaisseur est un sens de la largeur des conducteurs de câblage.

11. Appareil de conversion d'énergie selon la revendication 10, dans lequel les conducteurs de câblage sont agencés couplés de telle manière que les surfaces plates des conducteurs de la forme de plaque plate se font face les unes aux autres.

EP 3 128 665 B1

## FIG. 1A

## FIG. 1B

10

# FIG. 2A

# FIG. 2B

*FIG. 3*

# FIG. 4

## FIG. 5A

# FIG. 5B

# FIG. 6

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI51993300630 B
- JP HEI111999345724 B
- US 20130279085 A1